(19) Europäisches Patentamt

European Patent Office

Office européen des brevets

(11) **EP 1 145 437 B1**

(12) **EUROPÄISCHE PATENTSCHRIFT**

(45) Veröffentlichungstag und Bekanntmachung des Hinweises auf die Patenterteilung:
**30.07.2003 Patentblatt 2003/31**

(21) Anmeldenummer: **99936339.3**

(22) Anmeldetag: **28.05.1999**

(51) Int Cl.$^7$: **H03L 1/00**

(86) Internationale Anmeldenummer:
**PCT/DE99/01569**

(87) Internationale Veröffentlichungsnummer:
**WO 00/014879 (16.03.2000 Gazette 2000/11)**

(54) **DIGITALER PLL-FREQUENZSYNTHESIZER**

DIGITAL PHASE LOCKED LOOP FREQUENCY SYNTHESIZER

SYNTHETISEUR DE FREQUENCE NUMERIQUE A BOUCLE PLL

(84) Benannte Vertragsstaaten:
**FR GB**

(30) Priorität: **03.09.1998 DE 19840241**

(43) Veröffentlichungstag der Anmeldung:
**17.10.2001 Patentblatt 2001/42**

(73) Patentinhaber: **Infineon Technologies AG**
**81669 München (DE)**

(72) Erfinder:
• **GOSSMANN, Timo**
**D-81739 München (DE)**
• **GÖTZ, Edmund**
**D-85221 Dachau (DE)**

(74) Vertreter: **Fischer, Volker, Dipl.-Ing. et al**
**Epping Hermann & Fischer**
**Ridlerstrasse 55**
**80339 München (DE)**

(56) Entgegenhaltungen:
WO-A-86/07219　　　　GB-A- 2 107 142
US-A- 4 409 564　　　　US-A- 4 697 156
US-A- 5 907 253

Bemerkungen:
Derzeit sind die WIPO-Publikationsdaten A3 nicht verfügbar.

**Beschreibung**

Die Erfindung betrifft einen digitalen PLL(Phase Locked Loop)-Frequenzsynthesizer gemäß dem Oberbegriff des Patentanspruchs 1. Ein Sythesizer nach dem Oberbegriff des Anspruchs ist z.B. aus GB 2 107 142 bekannt.

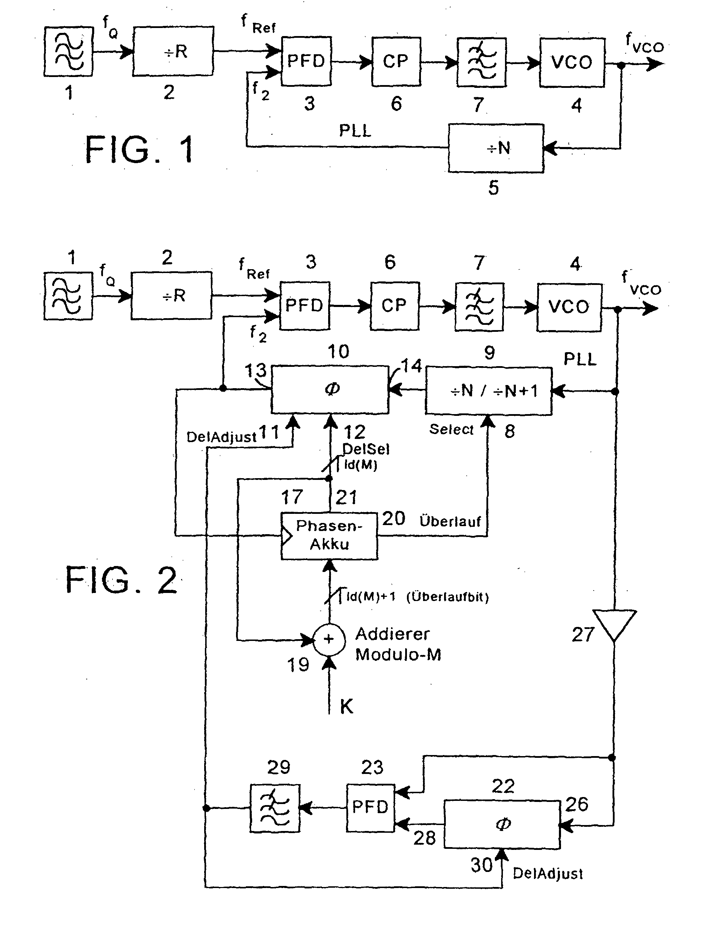

Gewöhnliche digitale PLL-Frequenzsynthesizer arbeiten nach dem in FIG. 1 in Blockschaltbildform abgebildeten, bekannten Prinzip. Eine Referenzfrequenz $f_{Ref}$, die durch Herunterteilen einer mit Hilfe eines quarzstabilen Oszillators 1 erzeugten stabilen Quarzfrequenz $f_Q$ um den Teilerfaktor 'R' mit Hilfe eines Referenzfrequenzteilers 2 gebildet wird, wird in einem Phasen-Frequenz-Detektor 3 mit einer zweiten Frequenz $f_2$ verglichen, die durch Teilen einer in einem spannungsgesteuerten Oszillator (VCO; Voltage Controlled Oscillator) 4 erzeugten Frequenz $f_{VCO}$ um den Teilerfaktor N abgeleitet wird. Diese Frequenzteilung um den Teilerfaktor 'N' findet in einem N-Frequenzteiler 5 statt. Der Phasen-Frequenz-Detektor 3 erzeugt - je nach Ausführung zusammen mit einer Ladungspumpe (Charge Pump) 6 - und einem Schleifen-Tiefpaßfilter 7 die Steuerspannung, welche den spannungsgesteuerten Oszillator 4 auf einer gewünschten Frequenz $f_{VCO}$ schwingen läßt.

Das durch den N-Frequenzteiler 5 einstellbare Teilerverhältnis 'N' ist ganzzahlig, was bedeutet, daß der spannungsgesteuerte Oszillator 4 bei eingerasteter Phasenregelschleife PLL nur auf einem ganzzahligen Vielfachen der Referenzfrequenz $f_{Ref}$ schwingen kann. Diese Tatsache bringt einige Nachteile mit sich.

Bei einem gewünschten geringen Abstand der im spannungsgesteuerten Oszillator 4 erzeugbaren Frequenzen $f_{VCO}$ muß eine niedrige Referenzfrequenz $f_{Ref}$ verwendet werden. Da die Phasenregelschleife PLL ein getastetes System mit der Abtastrate $f_{Ref}$ darstellt, kann nach dem Abtasttheorem (Nyquist-Theorem) die Bandbreite der Phasenregelschleife PLL nicht höher als $f_{Ref}/2$ gewählt werden, um ein stabiles System zu erhalten. In der Praxis liegt die Bandbreite gewöhnlich bei ca. 10% der Referenz frequenz $f_{Ref}$.

Eine geringe PLL-Schleifen-Bandbreite bedeutet allerdings ein langsames Einschwingverhalten beim Umschalten des N-Frequenzteilers 5, um eine andere Frequenz $f_{VCO}$ des spannungsgesteuerten Oszillators 4, d.h. einen anderen Frequenzkanal, einzustellen.

Ein anderer Nachteil rührt davon her, daß die Frequenz $f_{VCO}$ des spannungsgesteuerten Oszillators 4 sehr weit heruntergeteilt werden muß. Da die geteilte Frequenz $f_{VCO}$ mit der Referenzfrequenz $f_{Ref}$ verglichen wird, die ein geringes Phasenrauschen aufweisen muß, wird durch die PLL-Regelung das Phasenrauschen der geteilten Frequenz $f_{VCO}$ zwar optimiert, das Phasenrauschen des spannungsgesteuerten Oszillators 4 selbst verschlechtert sich jedoch mit größer werdendem Teilerfaktor 'N'.

Eine Referenzfrequenz $f_{Ref}$, die größer als das benötigte Kanalraster ist, kann dann verwendet werden, wenn der Teilerfaktor 'N' nicht mehr ganzzahlig eingestellt werden kann. Da der N-Frequenzteiler 5 selbst nur durch ganzzahlige Faktoren teilen kann, muß das gebrochene Teilerverhältnis im zeitlichen Mittel über M Zyklen eingestellt werden, d.h. für die Dauer von M-K Zyklen muß durch den Teilerfaktor 'N' und dann für die Dauer von K Zyklen durch den um die ganze. Zahl '1' erhöhten Teilerfaktor 'N+1' geteilt werden.

Dadurch ergibt sich bei eingeschwungener Phasenregelschleife PLL eine mittlere Frequenz $f_{VCO}$ des spannungsgesteuerten Oszillators 4 zu:

$$f_{VCO} = f_{Ref}{}^* (N+K/M).$$

Wenn von einer stabilen und entsprechend dem gewünschten gebrochenen Teilerverhältnis eingestellten Frequenz $f_{VCO}$ des spannungsgesteuerten Oszillators 4 ausgegangen wird, kann man zeigen, daß während den Zyklen, in denen durch den Teilungsfaktor 'N' geteilt wird, die Frequenz $f_{VCO}/N$ zu hoch ist und deshalb die Phasendifferenz zwischen der Referenzfrequenz $f_{Ref}$ und der Frequenz $f_{VCO}/N$ bei jedem Durchgang um den Faktor

$$T_{VCO\_soll}{}^*K/M$$

vergrößert wird.

Diese kumulierte Phasendifferenz wächst auf maximal eine VCO-Periodendauer des spannungsgesteuerten Oszillators 4 an und wird insgesamt in den Zyklen, in denen durch den Teilungsfaktor 'N+1' geteilt wird, gerade wieder aufgehoben, so daß nach M Perioden der Referenzfrequenz $f_{Ref}$ wieder Phasengleichheit zwischen der Referenzfrequenz $f_{Ref}$ und der geteilten Frequenz $f_{VCO}$ herrscht. Der Faktor M ist der Modulus, d.h. je größer der Faktor M ist, desto größer kann die Referenzfrequenz $f_{Ref}$ gewählt werden und desto kleinere Frequenzschritte, d.h. um so kleinere Frequenzkanalabstände können eingestellt werden.

Es sind Schaltungsvorschläge bekannt, die es mit Hilfe eines Phasenakkumulators ermöglichen, die Umschaltung des Teilerfaktors des N/(N+1)-Teilers automatisch abzuwickeln. In einem Phasenakkumulator wird auf den Inhalt nach jedem Impuls der geteilten Frequenz $f_{VCO}$ des spannungsgesteuerten Oszillators wieder der Wert K mit einer Modulo-M-Addition addiert. Nach jedem Überlauf des Phasenakkumulators wird im nächsten Zyklus der Teilerfaktor von 'N' auf 'N+1' geändert. Im Phasenakkumulator steht dadurch implizit immer ein Wert, der, mit dem Faktor $T_{VCO\_soll}/M$ multipliziert, den aktuellen Phasenwert am Phasen-Frequenz-Detektor darstellt.

Aufgrund der Phasendifferenz, die sich am Phasen-Frequenz-Detektor in jedem Zyklus einstellt, wird die PLL-Phasenregelschleife jedoch versuchen, den spannungsgesteuerten Oszillator (VCO) immer wieder auszuregeln, und wird somit die Phasenstabilität negativ beeinflussen. Für eine konstante VCO-Frequenz und -Phase wird deshalb eine konstante Stellspannung am spannungsgesteuerten Oszillator und somit eine große Zeitkonstante des Schleifen-Tiefpaßfilters benötigt, was dem Wunsch nach einer größeren Schleifen-Bandbreite gerade widerspricht.

Zur Erzielung einer Reduktion des Phasenjitters sind verschiedene Lösungsansätze bekannt geworden. Eine bekannte Methode (Firma "Marconi") besteht in der Verwendung mehrerer kaskadierter Phasenakkumulatoren, die nach dem Sigma-Delta-Prinzip die Frequenzanteile des Phasenjitters in Bereiche verschieben, die durch das Schleifen-Tiefpaßfilter stark gedämpft werden. Eine Kompensation ist dann nicht mehr erforderlich. Allerdings sind mehrere Phasenakkumulatoren erforderlich.

Eine andere bekannte Methode zur Reduzierung des Phasenjitters ist die aktive Kompensation der Regelung durch Eingriffe am Phasen-Frequenz-Detektor bzw. am Schleifen-Tiefpaßfilter. Dabei kann beispielsweise zusätzlich zum eigentlichen Ladungspumpenstrom ein Kompensationsstrom in das Schleifen-Tiefpaßfilter eingespeist werden, um den Effekt des erstgenannten Stromes auszugleichen. Dabei muß von Zyklus zu Zyklus entweder die Größe oder die Dauer der Einspeisung verändert werden, um eine vom Phasenfehler abhängige Ladungsmenge zur Kompensation zur Verfügung zu stellen.

Die einzelnen Abstufungen der unterschiedlichen Ladungsmengen hängen von der gewünschten Frequenz $f_{VCO}$ des spannungsgesteuerten Oszillators ab und sind z.B. als Funktion eines von der VCO-Frequenz/Periodendauer abhängenden Referenzstroms einstellbar. Bei den z.B. von der Firma "Philips" gebauten, sogenannten Fractional-N-Phasenregelschleifen (PLLs) wird das Stromkompensationsprinzip verwendet. Der Nachteil dieser Methode besteht in der erforderlichen Einstellung des Referenzstroms und im Eingriff am Schleifen-Tiefpaßfilter durch eine erweiterte Ladungspumpe.

Eine andere bekannte Methode zur Reduzierung des Phasenjitters, die von der Firma "National Semiconductor" verwendet wird, ist das zyklusabhängige aktive Verzögern der wirksamen Flanke der geteilten Frequenz $f_{VCO}$ des spannungsgesteuerten Oszillators. Auf Grund dieser Sache wird dem Phasen-Frequenz-Detektor stets eine Phasengleichheit vorgespielt und eine Nachregelung der PLL-Phasenregelschleife wird vermieden. Die relative Größe der benötigten Verzögerungen ist mit dem Inhalt des Phasenakkumulators korreliert. Lediglich die absolute Größe der Minimal-Verzögerung ist wiederum von der gewünschten Frequenz $f_{VCO}$ des spannungsgesteuerten Oszillators abhängig.

Mit Ausnahme der erwähnten, von der Firma "Marconi" eingesetzten Methode zur Reduzierung des Phasenjitters ist allen diesen bekannten Verfahren gemeinsam, daß sie eine Referenz entweder im Zeit- oder Spannungs- bzw. Strombereich benötigen, deren Größe von der zu synthetisierenden Frequenz abhängt.

Der Erfindung liegt die Aufgabe zugrunde, für einen digitalen, fractional-N basierten PLL-Frequenzsynthesizer eine Möglichkeit der Phasenfehlerkompensation zu schaffen, bei der alle benötigten Stell- und Referenzsignale aus der Frequenz $f_{VCO}$ des spannungsgesteuerten Oszillators (VCO) abgeleitet werden können.

Diese Aufgabe wird bei einem gattungsgemäßen digitalen PLL-Frequenzsynthesizer durch die im kennzeichnenden Teil des Patentanspruchs 1 angegebenen Merkmale gelöst.

Zweckmäßige Weiterbildungen der Erfindung sind in den Unteransprüchen angegeben.

Die Erfindung und deren Weiterbildungen sowie die Vorteile der Erfindung werden im folgenden anhand eines in Zeichnungen dargestellten Ausführungsbeispiels erläutert. Es zeigen:

FIG. 1 das bereits in der Beschreibungseinleitung beschriebene Blockschaltbild eines gewöhnlichen, bekannten PLL-Frequenzsynthesizers,

FIG. 2 das Blockschaltbild eines Fractional-N-PLL-Frequenzsynthesizers nach der Erfindung,

FIG. 3 in einem Blockschaltbild den Aufbau einer in der Schaltung nach FIG. 2 vorgesehenen PLL-Phasenverzögerungseinrichtung mit M-1 Verzögerungselementen und einem M:1-Multiplexer, und

FIG. 4 in einem Blockschaltbild den Aufbau einer weiteren, in der Schaltung nach FIG. 2 vorgesehenen Phasenverzögerungseinrichtung mit M Verzögerungselementen.

In FIG. 2 ist als Blockschaltbild die Schaltung eines entsprechend der Erfindung ausgeführten digitalen PLL(Phase Lokked Loop)-Frequenzsynthesizers dargestellt. Es sind auch in dieser Schaltung die bekannten Elemente einer gewöhnlichen und bereits im Zusammenhang mit der FIG. 1 beschriebenen PLL-Frequenzsynthesizerschaltung zu sehen, nämlich ein quarzstabiler Oszillator 1, ein Referenzfrequenzteiler 2, ein Phasen-Frequenz-Detektor 3, eine Ladungspumpe (Charge-Pump) 6, ein Schleifen-Tiefpaßfilter 7 und ein spannungsgesteuerter Oszillator (VCO) 4.

Bei dem in FIG. 2 dargestellten Frequenzsynthesizer wird eine Referenzfrequenz $f_{Ref}$, die durch Teilung der vom quarzstabilisierten Oszillator 1 gelieferten Quarzfrequenz $f_Q$ im Referenzfrequenzteiler 2 gebildet wird, mit einer zweiten, durch Teilen der Frequenz $f_{VCO}$ des spannungsgesteuerten Oszillators 4 abgeleiteten

Frequenz $f_2$ im Phasen-Frequenz-Detektor 3 verglichen, dessen Ausgangssignal nach Leitung über die Ladungspumpe (Charge Pump) 6 und das Schleifen-Tiefpaßfilter 7 in der PLL-Schleife als Steuerspannung für den spannungsgesteuerten Oszillators 4 dient.

Zur Teilung der Frequenz des spannungsgesteuerten Oszillators 4 ist in der PLL-Schleife im Gegensatz zur anhand der FIG. 1 beschriebenen, bekannten Frequenzsynthesizer-Schaltung ein zwischen zwei benachbarten ganzzahligen Teilerfaktoren N und N+1 an einem Steuereingang 8 (Select) umschaltbarer und in der Grundteilung durch n programmierbarer N/(N+1)-Frequenzteiler 9 vorgesehen, der gegebenenfalls nach dem Dual-Modulus-Prinzip realisiert ist.

Zwischen dem Frequenzteiler 9 und dem Eingang für die Frequenz $f_2$ am Phasen-Frequenz-Detektor 3 ist ebenfalls anders als bei der bekannten Schaltung nach FIG. 1 noch eine Phasenverzögerungseinrichtung 10 eingeschaltet, welche zwei Steuereingänge 11 (Del-Adjust) bzw. 12 (DelSel) besitzt, wobei der Steuereingang 12 durch mehrere Leitungen realisiert ist und beispielsweise + ein Bus mit ld(M) Leitungen sein kann. Am Steuereingang 11 wird eine Grundverzögerung eingestellt, und am Steuereingang 12 wird eingestellt, um wie viele dieser Grundverzögerungen später der Ausgang 13 der Phasenverzögerungseinrichtung 10 deren Eingang 14 folgt.

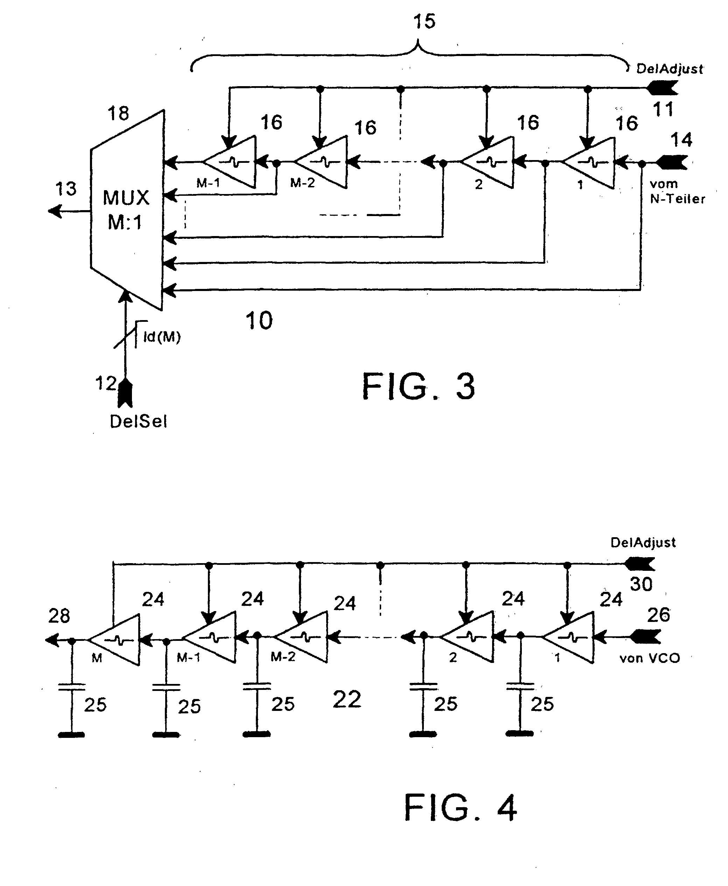

Wie die den Aufbau der PLL-Phasenverzögerungseinrichtung 10 im einzelnen darstellende FIG. 3 zeigt, sind - entsprechend dem gewählten Modulus M - in der Phasenverzögerungskette 15 M-1 Verzögerungselemente 16 enthalten, die jeweils die gleiche, allerdings über den Steuereingang 11 einstellbare Verzögerungszeit aufweisen. Mit Hilfe des decodierten DelSel-Signalwertes vom Steuereingang 12 wird ausgewählt, hinter welchem Verzögerungselement 16 das Signal für den Phasen-Frequenz-Detektor 3 und einen Phasenakkumulator 17 ausgekoppelt wird.

Der zur Einstellung der Anzahl der in der Phasenverzögerungskette 15 der PLL-Phasenverzögerungseinrichtung 10 wirksamen Grundverzögerungen vorgesehene Steuereingang 12 ist zugleich der Steuereingang eines M:1-Multiplexers 18, mittels welchem sich in Abhängigkeit vom an seinem Steuereingang liegenden Steuersignal auswählen läßt, hinter welchem der in Reihe geschalteten Verzögerungselemente 16 das einerseits dem einen Eingang des Phasen-Frequenz-Detektors 3 und andererseits dem Phasenakkumulator 17 zuzuführende Signal ausgekoppelt wird. Durch die Verwendung eines Multiplexers zur Auswahl der Anzahl der Verzögerungselemente kann die oben erwähnte Dekodierung gegebenenfalls sogar entfallen.

Der Phasenakkumulator 17 wird mit jedem Ausgangsimpuls der Phasenverzögerungseinrichtung 10 um den einstellbaren Bruchteil K der Referenzfrequenz $f_{Ref}$ erhöht, allerdings Modulo-M, wozu ein Addierer-Modulo-M 19 vorgesehen ist. Bei einem Überlauf wird über einen Überlauf-Ausgang 20 des Phasenakkumulators 17 der N/(N+1)-Frequenzteiler 9 für die nächste Periode auf den Teilerfaktor (N+1) geschaltet. Der Ausgang 21 des Phasenakkumulators 17 stellt direkt das Steuerwort DelSel für den Steuereingang 12 der PLL-Phasenverzögerungseinrichtung 10 bereit.

Wie in der Beschreibung bereits früher erwähnt wurde, ist der zu kompensierende Phasenfehler sowohl eine Funktion der Zyklennummer innerhalb M aufeinanderfolgender Zyklen als auch eine Funktion der gewünschten Frequenz $f_{VCO}$ des spannungsgesteuerten Oszillators 4. Es läßt sich aufzeigen, was vorher bereits erfolgt ist, daß deshalb die benötigte zyklenabhängige Zeit zur Verzögerung der geteilten $f_{VCO}$-Phase ein ganzzahliges Vielfaches von

$$T_{delmin} = 1/(f_{VCO\_soll}*M)$$

betragen muß.

Wesentlich beim Verfahren nach der Erfindung ist der Schritt, daß die Steuerspannung DelAdjust, mit der diese Zeit $T_{delmin}$ über den Steuereingang 11 an jedem Verzögerungselement 16 der Phasenverzögerungskette 15 in der Phasenverzögerungseinrichtung 10 eingestellt wird, mit Hilfe einer weiteren Phasenverzögerungseinrichtung 22 und eines weiteren Phasen-Frequenz-Detektors 23 direkt aus der Frequenz $f_{VCO}$ des spannungsgesteuerten Oszillators 4 abgeleitet wird.

Wie FIG. 4 zeigt, ist die weitere Phasenverzögerungseinrichtung 22 genauso aufgebaut wie die Phasenverzögerungseinrichtung 10, d.h. sie ist entsprechend den Auskoppelleitungen bei den Verzögerungselementen 16 der Phasenverzögerungseinrichtung 10 nach FIG. 3 bei allen Verzögerungseiementen 24 durch Dummy-Auskoppelelemente 25 belastet, um die gleichen Verzögerungsbedingungen wie in der mit dem M:1-Multiplexer 18 ausgestatteten PLL-Phasenverzögerungseinrichtung 10 nachzubilden. Allerdings sind in der weiteren Phasenverzögerungseinrichtung 22 nicht M-1 Verzögerungselemente wie bei der Phasenverzögerungseinrichtung 10, sondern M Verzögerungselemente 24 hintereinandergeschaltet, was von großer Bedeutung ist.

In die weitere Phasenverzögerungseinrichtung 22 wird an einem Eingang 26 die Frequenz $f_{VCO}$ des spannungsgesteuerten Oszillators 4 über einen Pufferverstärker 27 eingespeist, und die Phase des Signals am Ausgang 28 der weiteren Phasenverzögerungseinrichtung 22 wird wiederum mit Hilfe des weiteren Phasen-Frequenz-Detektors 23 direkt mit der über den gleichen Pufferverstärker 26 geleiteten Frequenz $f_{VCO}$ des spannungsgesteuerten Oszillators 4 verglichen. Das vom Ausgang 28 der weiteren Phasenverzögerungseinrichtung 22 abgeleitete Vergleichsergebnis wird in einem zweiten Schleifen-Tiefpaßfilter 29 tiefpaßgefiltert und bildet dann für die weitere Phasenverzögerungseinrichtung 22 die Steuerspannung, die dort einem Steuereingang 30 zugeführt wird.

Mit dieser Steuerspannung DelAdjust wird bei den Verzögerungselementen 24 der weiteren Phasenverzögerungseinrichtung 22 die jeweils gleiche Grundverzögerung eingestellt. Die weitere Phasenverzögerungseinrichtung 22 ist mithin also quasi ein Bestandteil einer Hilfs-Phasenregelschleife (Hilfs-PLL), bei welcher der spannungsgesteuerte Oszillator 4 seine eigene Referenzfrequenz erzeugt. Wegen der hohen Frequenzen kann die Hilfs-PLL eine sehr hohe Schleifen-Bandbreite haben.

Es genügt jedoch ein Wert, der in der Größenordnung der Referenzfrequenz $f_{Ref}$ liegt, da ein wesentlich schnelleres DelAdjust-Steuersignal auch nicht schneller ausgewertet werden kann. Wenn sichergestellt wird, daß in der weiteren Phasenverzögerungseinrichtung 22 genau eine VCO-Periode der Schwingung des spannungsgesteuerten Oszillators 4 enthalten ist, gilt:

$$T_{22} = M*T_{delmin} = T_{VCO\_soll}.$$

Dies bedeutet, daß jedes Verzögerungselement 24 der weiteren Phasenverzögerungseinrichtung 22 um genau den M-ten Teil von $T_{VCO\_soll}$ verzögert.

Dies ist genau der benötigte Elementarwert der in der eigentlichen, also in der Phasenverzögerungseinrichtung 10 der Haupt-PLL enthaltenen Phasenverzögerungskette 15. Weil die Verzögerungselemente 16 bzw. 24 in beiden Phasenverzögerungseinrichtungen 10 bzw. 22 bezüglich ihres zeitlichen Verhaltens gleich aufgebaut sind, kann die Steuerspannung für die weitere Phasenverzögerungseinrichtung 22 auch als Steuerspannung DelAdjust zur Zuführung an den Steuereingang 11 der Phasenverzögerungseinrichtung 10 verwendet werden.

Ein entsprechend der Erfindung ausgebildeter Frequenzsynthesizer läßt sich in besonders vorteilhafter Weise in integrierter Schaltkreistechnik ausführen.

## Patentansprüche

**1.** Digitaler PLL(Phase Locked Loop)-Frequenzsynthesizer, bei dem eine durch Teilung einer stabilen Quarzoszillatorfrequenz ($f_Q$) gebildete Referenzfrequenz ($f_{Ref}$) mit einer zweiten, durch Teilen der Frequenz eines spannungsgesteuerten Oszillators (VCO) abgeleiteten Frequenz ($f_{VCO}$) in einem Phasen-Frequenz-Detektor (3) verglichen wird, dessen Ausgangssignal nach Leitung über ein Schleifen-Tiefpaßfilter (7) in einer Schleife der PLL als Steuerspannung für den spannungsgesteuerten Oszillators dient, wobei zur Teilung der Frequenz des spannungsgesteuerten Oszillators in der Schleife der PLL ein zwischen zwei benachbarten ganzzahligen Teilerfaktoren N und N+1 umschaltbarer, für die Dauer von M-K Zyklen durch N teilender und dann für die Dauer von K Zyklen durch N+1 teilender N/(N+1)-Frequenzteiler (9) vorgesehen ist und zur Herbeiführung einer automatischen Umschaltung des N/(N+1)-Frequenzteilers ein Phasenakkumulator (17) vorgesehen sind, zu dessen Inhalt mit jedem Impuls der geteilten VCO-Frequenz der Wert K mit einer Modulo-M-Addition addiert wird und der nach jedem Überlauf im nächsten Zyklus eine Änderung des Teilerfaktors von N auf N+1 veranlaßt, **dadurch gekennzeichnet, daß**
zwischen dem N/(N+1)-Frequenzteiler (9) und dem von diesem Frequenzteiler angesteuerten Eingang des Phasen-Frequenz-Detektors (3) und dem Eingang des Phasenakkumulators (17) eine Phasenverzögerungseinrichtung (10) eingefügt ist, die in einer Phasenverzögerungskette (15) M-1 Verzögerungselemente (16) enthält und die zwei Steuereingänge (11, 12) aufweist, von denen der eine (11) zur Einstellung der jeweils übereinstimmenden Größe der Grundverzögerungen der Verzögerungselemente der Phasenverzögerungskette und der andere (12) zur Einstellung der Anzahl der in dieser Phasenverzögerungskette wirksamen Grundverzögerungen vorgesehen ist, daß der Inhalt des Phasenakkumulators (17) mit jedem Ausgangsimpuls der Phasenverzögerungseinrichtung (10) um den einstellbaren Bruchteil K der Referenzfrequenz Modulo-M erhöht wird und bei einem Überlauf der N/(N+1)-Frequenzteiler für die nächste Periode auf N+1 geschaltet wird, daß der Ausgang (21) des Phasenakkumulators (17) mit dem zur Einstellung der Anzahl der wirksamen Grundverzögerungen vorgesehenen Steuereingang (12) der Phasenverzögerungseinrichtung (10) verbunden ist, und daß eine weitere Phasenverzögerungseinrichtung (22), die M hintereinandergeschaltete Verzögerungselemente (24) aufweist, zwischen dem Ausgang des spannungsgesteuerten Oszillators (4) und dem einen Eingang eines weiteren Phasen-Frequenz-Detektors (23) eingefügt ist, daß an einem zweiten Eingang des weiteren Phasen-Frequenz-Detektors (23) der Ausgang des spannungsgesteuerten Oszillators (4) ohne Zwischenschaltung von Verzögerungselementen angeschlossen ist und daß mit einem Ausgang des weiteren Phasen-Frequenz-Detektors (23) über ein weiteres Schleifen-Tiefpaßfilter (29) unter Bildung einer Hilfs-PLL-Schleife die zur Einstellung der jeweils übereinstimmenden Größe der Grundverzögerungen der Verzögerungselemente vorgesehenen Steuereingänge (11, 30) der beiden Phasenverzögerungseinrichtungen (10, 22) verbunden sind.

**2.** Frequenzsynthesizer nach Anspruch 1, **dadurch gekennzeichnet, daß** der zur Einstellung der Anzahl der in der Phasenverzögerungseinrichtung (10) wirksamen Grundverzögerungen vorgesehene Steuereingang (12) durch den Steuereingang eines M:1-Multiplexers (18) gebildet ist, mittels welchem sich in Abhängigkeit vom an seinem Steuereingang liegenden Steuersignal auswählen läßt, hinter welchem der in Reihe geschalteten Verzögerungselemente (16) das einerseits dem einen Eingang des Phasen-Frequenz-Detektors (3) und andererseits dem Phasenakkumulator (17) zuzuführende Signal ausgekoppelt wird.

3. Frequenzsynthesizer nach Anspruch 1, **dadurch gekennzeichnet, daß** die weitere Phasenverzögerungseinrichtung (22) zur Nachbildung von Verzögerungsbedingungen, die mit denjenigen der Phasenverzögerungseinrichtung (10) übereinstimmen, außer den Verzögerungselementen (24) selbst diesen letzteren zugeordnete Dummy-Auskoppelemente (25) enthält.

4. Frequenzsynthesizer nach den Ansprüchen 2 und 3, **dadurch gekennzeichnet, daß** die Dummy-Auskoppelelemente (25) Lastelemente sind, welche die Belastung durch den Eingang des M:1-Multiplexers (18) der PLL-Phasenverzögerungseinrichtung (10) nachbilden.

5. Frequenzsynthesizer nach einem der vorhergehenden Ansprüche, **dadurch gekennzeichnet, daß** die unter anderem den weiteren Phasen-Frequenz-Detektor (22) enthaltende Hilfs-PLL-Schleife so ausgelegt ist, daß sie eine sehr hohe Schleifenbandbreite aufweist.

6. Frequenzsynthesizer nach Anspruch 5, **dadurch gekennzeichnet, daß** die Hilfs-PLL-Schleife so ausgelegt ist, daß ihre Bandbreite in der Größenordnung der Referenzfrequenz ($f_{Ref}$) liegt.

7. Frequenzsynthesizer nach einem der vorhergehenden Ansprüche, **gekennzeichnet durch** eine Ausführung in integrierter Schaltkreistechnik.

8. Frequenzsynthesizer nach einem der vorhergehenden Ansprüche,
   **dadurch gekennzeichnet, daß**
   eine Ladungspumpe (6) zwischen den Phasen-Frequenz-Detektor (3) und das Schleifenfilter (7) geschaltet ist.

**Claims**

1. Digital PLL (Phase-Locked Loop) frequency synthesizer, in which a reference frequency ($f_{Ref}$) formed by division of a stable quartz oscillator frequency ($f_Q$) is compared with a second frequency ($f_{VCO}$), derived by dividing the frequency of a voltage-controlled oscillator (VCO), in a phase-frequency detector (3) whose output signal serves, after being led via a loop low-pass filter (7) in a loop of the PLL, as control voltage for the voltage-controlled oscillator, there being provided for the purpose of dividing the frequency of the voltage-controlled oscillator in the loop of the PLL an N/(N+1) frequency divider, which can be switched over between two adjacent integral divider factors N and N+1, divides by N for the duration of M-K cycles, and then divides by N+1 for the duration of K cycles, and for the purpose of causing automatic switching over of the N/(N+1) frequency divider (9) a phase accumulator (17) to whose contents the value K with a modulo-M addition is added with each pulse of the divided VCO frequency and which causes a change in the divider factor from N to N+1 in the next cycle after each overflow, **characterized in that** inserted between the N/(N+1) frequency divider (9) and the input, driven by this frequency divider, of the phase-frequency detector (3) and the input of the phase accumulator (17) is a phase delay device (10) which contains M-1 time-delay elements (16) in a phase delay chain (15) and has two control inputs (11, 12) of which one (11) is provided for setting the respectively corresponding magnitude of the fundamental delays of the time-delay elements of the phase delay chain, and the other (12) is provided for setting the number of the fundamental delays active in this phase delay chain, **in that** the contents of the phase accumulator (17) are increased with each output pulse of the phase delay device (10) by the adjustable fraction K of the reference frequency modulo-M, and in the event of an overflow the N/(N+1) frequency divider is switched to N+1 for the next period, **in that** the output (21) of the phase accumulator (17) is connected to the control input (12) of the phase delay device (10) which is provided for setting the number of the active fundamental delays, and **in that** a further phase delay device (22), which has M series-connected time-delay elements (24), is inserted between the output of the voltage-controlled oscillator (4) and one input of a further phase-frequency detector (23), **in that** at a second input of the further phase-frequency detector (23) the output of the voltage-controlled oscillator (4) is connected without the interposition of time-delay elements, and **in that** to an output of the further phase-frequency detector (23) there are connected via a further loop low pass filter (21) and with the formation of an auxiliary PLL the control inputs (11, 30), provided for setting the respectively corresponding magnitude of the fundamental delays of the time-delay elements, of the two phase delay devices (10, 22).

2. Frequency synthesizer according to Claim 1, **characterized in that** the control input (12) provided for setting the number of the fundamental delays active in the phase delay device (10) is formed by the control input of an M:1 multiplexer (18) by means of which it is possible to select, as a function of the control signal present at its control input, downstream of which of the time-delay elements (16) connected in series the signal to be fed to one input of the phase-frequency detector (3), on the one hand, and to be fed to the phase accumulator (17), on the other hand, is decoupled.

3. Frequency synthesizer according to Claim 1, **characterized in that** for the purpose of simulating time-delay conditions which correspond to those of the phase delay device (10), apart from the time-delay elements (24) themselves, the further phase delay device (22) includes dummy decoupling elements (25) assigned to the latter.

4. Frequency synthesizer according to Claims 2 and 3, **characterized in that** the dummy decoupling elements (25) are load elements which simulate the loading by the input of the M:1 multiplexer (18) of the PLL phase delay device (10).

5. Frequency synthesizer according to one of the preceding claims, **characterized in that** the auxiliary PLL including, inter alia, the further phase-frequency detector (22), is designed such that it has a very high loop bandwidth.

6. Frequency synthesizer according to Claim 5, **characterized in that** the auxiliary PLL is designed such that its bandwidth is of the order of magnitude of the reference frequency ($f_{Ref}$).

7. Frequency synthesizer according to one of the preceding claims, **characterized by** being embodied using integrated circuit technology.

8. Frequency synthesizer according to one of the preceding claims, **characterized in that** a charge pump (6) is connected between the phase-frequency detector (3) and the loop filter (7).

**Revendications**

1. Synthétiseur de fréquence numérique à boucle à verrouillage de phase PLL (Phase Locked Loop), dans lequel une fréquence de référence ($f_{Ref}$) formée par division d'une fréquence stable d'oscillateur à quartz ($f_Q$) est comparée à une deuxième fréquence ($f_{VCO}$) déduite par division de la fréquence d'un oscillateur commandé en tension (VCO) dans un détecteur phase-fréquence (3) dont le signal de sortie sert, après passage par un filtre passe-bas de boucle (7) dans une boucle de la PLL comme tension de commande pour l'oscillateur commandé en tension, dans lequel, pour la division de la fréquence de l'oscillateur commandé par tension dans la boucle de la PLL, il est prévu un diviseur de fréquence N / (N + 1) (9) qui peut être commuté entre deux facteurs de division entiers voisins N et N + 1, qui divise par N pour la durée de M - K cycles et qui divise ensuite par N + 1 pour la durée de K cycles et dans lequel, pour le déclenchement d'une commutation automatique du diviseur de fréquence N / (N + 1), il est prévu un accumulateur de phase (17) au contenu duquel est ajoutée à chaque impulsion de la fréquence VCO divisée la valeur K avec une addition modulo M et qui provoque après chaque débordement une modification du facteur de division de N à N + 1 dans le cycle suivant,

**caractérisé par le fait que**

il est inséré entre le diviseur de fréquence N / (N + 1) (9) et l'entrée, commandée par ce diviseur de fréquences du détecteur phase-fréquence (3) et l'entrée de l'accumulateur de phase (17) un dispositif de retardement de phase (10) qui contient M -1 éléments à retard (16) dans une ligne à retard de phase (15) et qui comporte deux entrées de commande (11, 12) dont l'une (11) est prévue pour le réglage de la grandeur respectivement coïncidente des retards fondamentaux des éléments à retard de la ligne à retard de phase et dont l'autre (12) est prévue pour le réglage du nombre des retards fondamentaux actifs dans cette ligne à retard de phase, le contenu de l'accumulateur de phase (17) est augmenté modulo M, à chaque impulsion de l'accumulateur de phase (17) est augmenté modulo M, à chaque impulsion de sortie du dispositif de retardement de phase (10), de la fraction réglable K de la fréquence de référence et, lors d'un débordement, le diviseur de fréquence N / (N + 1) est commuté sur N + 1 pour la période suivante, la sortie (21) de l'accumulateur de phase (17) est reliée à l'entrée de commande (12), prévue pour le réglage du nombre des retards fondamentaux actifs, du dispositif de retardement de phase (10), et un autre dispositif de retardement de phase (22) qui comporte M éléments à retard (24) branchés les uns derrière les autres est inséré entre la sortie de l'oscillateur commandé en tension (4) et une entrée d'un autre détecteur phase-fréquence (23), la sortie de l'oscillateur commandé en tension (4) est raccordée, sans éléments à retard intercalés, à une deuxième entrée de l'autre détecteur phase-fréquence (23) et que les entrées de commande (11, 30), prévues pour le réglage de la grandeur respectivement coïncidente des retards fondamentaux des éléments à retard, des deux dispositifs de retardement de phase (10, 22) sont reliées à une sortie de l'autre détecteur phase-fréquence (23) par l'intermédiaire d'un autre filtre passe-bas de boucle (29) en formant une boucle PLL auxiliaire.

**2.** Synthétiseur de fréquence selon la revendication 1, **caractérisé par le fait que** l'entrée de commande (12) prévue pour le réglage du nombre des retards fondamentaux actifs dans le dispositif de retardement de phase (10) est formée par l'entrée de commande d'un multiplexeur M : 1 (18) au moyen duquel on peut sélectionner en fonction du signal de commande présent à son entrée de commande celui des éléments à retard (16) branchés en série derrière lequel est découplé le signal à envoyer d'une part à une entrée du détecteur phase-fréquence (3) et d'autre part à l'accumulateur de phase (17).

**3.** Synthétiseur de fréquence selon la revendication 1, **caractérisé par le fait que** l'autre dispositif de retardement de phase (22) pour la simulation de conditions de retardement qui coïncident avec celles du dispositif de retardement de phase (10) contient, outre les éléments à retard (24) eux-mêmes, des éléments de découplage fictifs (25) associés à ces derniers.

**4.** Synthétiseur de fréquence selon les revendications 2 et 3, **caractérisé par le fait que** les éléments de découplage fictifs (25) sont des éléments de charge qui simulent la charge par l'entrée du multiplexeur M : 1 (18) du dispositif de retardement de phase de PLL (10).

**5.** Synthétiseur de fréquence selon l'une des revendications précédentes, **caractérisé par le fait que** la boucle PLL auxiliaire contenant entre autres l'autre détecteur phase-fréquence (22) est conçue de telle sorte qu'elle présente une très grande largeur de bande de boucle.

**6.** Synthétiseur de fréquence selon la revendication 5, **caractérisé par le fait que** la boucle PLL auxiliaire est conçue de telle sorte que sa largeur de bande est de l'ordre de la fréquence de référence ($f_{Ref}$).

**7.** Synthétiseur de fréquence selon l'une des revendications précédentes, **caractérisé par** une réalisation sous forme de circuit intégré.

**8.** Synthétiseur de fréquence selon l'une des revendications précédentes, **caractérisé par le fait qu'**une pompe de charge (6) est branchée entre le détecteur phase-fréquence (3) et le filtre de boucle (7).

FIG. 1

FIG. 2

FIG. 3

FIG. 4